# EUROPEAN PATENT APPLICATION

(11) **EP 4 701 347 A1**
(43) Date of publication of application: **25.02.2026**
(21) Application number: 23937823.5
(22) Date of filing: 19.05.2023
(51) Int. Cl.: H05K 1/02, H01L 23/36

(54) **POWER SUPPLY MODULE AND CHARGING DEVICE**

(71) Applicant: Huawei Digital Power Technologies Co., Ltd., Shenzhen, Guangdong 518043 (CN)
(72) Inventor: LI, Hongtao, Shenzhen, Guangdong 518043 (CN); ZHAO, Dongsheng, Shenzhen, Guangdong 518043 (CN); CHEN, Changhao, Shenzhen, Guangdong 518043 (CN); ZUO, Peng, Shenzhen, Guangdong 518043 (CN)
(74) Representative: Isarpatent
(86) International application number: PCT/CN2023/095279
(87) International publication number: WO 2024/239144

(57) **Abstract**

This application provides a power module and a charging device. The power module includes a substrate, a power component, and a heat sink. The substrate includes at least two conductive layers, the at least two conductive layers are stacked along a thickness direction of the substrate, and an insulating dielectric layer is disposed between any two adjacent conductive layers. The at least two conductive layers include a first conductive layer and a second conductive layer, and the first conductive layer and the second conductive layer are respectively located on two surfaces in the thickness direction of the substrate. The power component is disposed on a surface that is of the first conductive layer and that is away from the second conductive layer, and the heat sink is disposed on a surface that is of the second conductive layer and that is away from the first conductive layer.

## Description

### TECHNICAL FIELD

This application relates to the field of heat dissipation technologies, and in particular, to a power module and a charging device.

### BACKGROUND

A surface-mount technology (surface-mount technology, SMT) is a common technology and technique in an electronic assembly industry. Because of high assembly density and reliable performance, the surface-mount technology is applied to an electronic component assembly structure which requires high power density. A power module is used as an example. A surface-mounted power component helps improve power density of a power supply. However, a heat dissipation problem of the surface-mounted power component has always been a difficult problem in product design. In product design, performance and heat dissipation both need to be considered, and electromagnetic interference of the power component needs to be considered.

### SUMMARY

This application provides a power module and a charging device. The power module has high heat dissipation efficiency, and can further avoid electromagnetic interference caused by a heat sink carrying electricity.

According to a first aspect, this application provides a power module. The power module specifically includes a substrate, a power component, and a heat sink. The substrate is of a multi-layer line board structure, and specifically includes at least two conductive layers. The at least two conductive layers are stacked along a thickness direction of the substrate, and an insulating dielectric layer is disposed between any two adjacent conductive layers. Specifically, the at least two conductive layers include a first conductive layer and a second conductive layer, and the first conductive layer and the second conductive layer are respectively located on two surfaces in the thickness direction of the substrate. The power component is disposed, by using a surface-mount technology, on a surface that is of the first conductive layer and that is away from the second conductive layer. This can reduce a structure volume and facilitate realization of component miniaturization. The heat sink is disposed on a surface that is of the second conductive layer and that is away from the first conductive layer. This can fully utilize space on the side of the substrate away from the power component, increase a heat exchange area of the heat sink, and improve heat dissipation efficiency. Heat generated by the power component may be transferred to the heat sink by using the substrate, and then the heat sink transfers the heat to the outside through heat exchange. In addition, an insulating dielectric layer in the substrate can be used to isolate the second conductive layer from another conductive layer, to prevent the heat sink from carrying electricity.

The power module, the power component, and the heat sink are integrated on two sides in the thickness direction of the substrate. Heat dissipated by the power component may be transferred to the heat sink by using the substrate, and heat dissipation is implemented by using the heat sink. The power component is welded on the substrate by using the surface-mount technology. This can improve space utilization. The heat sink and the power component are respectively located on the two sides of the thickness direction of the substrate, so that the heat sink can have a relatively large volume to improve heat dissipation efficiency. In addition, a dielectric layer is disposed between two adjacent conductive layers in the substrate, so that the heat sink can be grounded through the dielectric layer, thereby preventing electromagnetic interference caused by the heat sink carrying electricity.

In some possible implementations, the at least two conductive layers further include at least one intermediate conductive layer disposed between the first conductive layer and the second conductive layer. The second conductive layer and an intermediate conductive layer that is closest to the second conductive layer are mutually insulated, to ensure electrical insulation of the heat sink connected to the second conductive layer.

Specifically, along a direction from the second conductive layer to the first conductive layer, an insulating dielectric layer between the second conductive layer and the intermediate conductive layer that is closest to the second conductive layer has no metal via hole, so that the second conductive layer and the intermediate conductive layer that is closest to the second conductive layer are insulated from each other, and the heat sink is insulated from another conductive layer except the second conductive layer.

In some possible implementations, on the premise that a heat conduction rate of the conductive layer is higher than a heat conduction rate of the insulating dielectric layer, to improve a heat transfer rate, another conductive layer except the second conductive layer may be connected through a metal via hole. In the at least one intermediate conductive layer and the first conductive layer, a metal via hole is disposed between any two adjacent conductive layers, and the metal via hole specifically runs through the insulating dielectric layer between the two conductive layers. The metal via hole can quickly direct heat from one conductive layer to another conductive layer. The metal via hole may be implemented by filling a metal material in the hole, or may be implemented by electroplating a conductive layer on an inner wall of the hole. To improve heat dissipation efficiency, metal hole holes at different insulating dielectric layers may approximately correspond to each other along the thickness direction of the substrate, so that a heat dissipation path basically extends along the thickness direction of the substrate, and the metal via holes are on the heat dissipation path for heat transfer. Such a structure can shorten the heat dissipation path as much as possible, and improve a heat dissipation rate.

To simplify a manufacturing technique, metal via holes at different insulating dielectric layers may be formed by one-time drilling. For example, the metal via hole may extend from the first conductive layer to the intermediate conductive layer that is closest to the second conductive layer. Alternatively, the intermediate conductive layers are connected through a first metal via hole, and the first conductive layer is connected to the intermediate conductive layer that is closest to the first conductive layer through a second metal via hole. In this case, along the thickness direction of the substrate, the first metal via hole may not correspond to the second metal via hole.

In a possible implementation, the heat sink is connected to the substrate through a plurality of heat dissipation pads. There is a gap between adjacent heat dissipation pads, so that compact on reliability and stability of a connection between the power component and the substrate caused by deformation of the heat sink can be prevented. The power component includes a control electrode, and the control electrode may be specifically a gate electrode. An orthographic projection of a welding position of the control electrode and the first conductive layer on the second conductive layer does not overlap an orthographic projection of any heat dissipation pad on the second conductive layer. In other words, a connection position between the control electrode and the first conductive layer is away from a position of the heat dissipation pad of the heat sink. This helps improve reliability of the component.

The power component further includes a connection electrode, and the connection electrode may be specifically a source electrode or a drain electrode. To shorten the heat dissipation path, the heat dissipation pad, the metal via hole, and the connection electrode may correspond to each other along the thickness direction of the substrate. In this way, in a process of transferring heat dissipated by the power component to the heat sink, the heat dissipation path can be kept parallel to the thickness direction of the substrate as much as possible, so as to achieve a quick heat dissipation effect.

The power module provided in this application further includes a capacitor component. The capacitor component may be disposed on the surface that is of the first conductive layer and that is away from the second conductive layer, or may be embedded in the substrate. The capacitor component may form a power conversion circuit with the power component through the first conductive layer. During operation, the power conversion circuit can convert a current of a power supply and then supply the converted current to a power-consuming device for use.

According to a second aspect, this application provides a charging device. The charging device may be specifically an apparatus such as a charging pile or a charger. The charging device includes at least one charging interface and at least one power module provided in the first aspect. An input end of the charging interface is configured to be connected to an output end of the power module; and an output end of the charging interface is configured to be connected to a power-consuming device, to transmit, to the power-consuming device, a current output by the power module. A connection relationship between the power module and the charging interface is not limited. Each power module may be connected to one charging interface, or each power module may be connected to one or more charging interfaces.

### BRIEF DESCRIPTION OF DRAWINGS

FIG. 1 is a schematic diagram of a structure of a power module according to an embodiment of this application;
FIG. 2a is a schematic diagram of a structure of a power module according to an embodiment of this application;
FIG. 2b is a schematic diagram of a heat dissipation path of the power module shown in FIG. 2a;
FIG. 3a is a schematic diagram of a structure of a power module according to an embodiment of this application;
FIG. 3b is a schematic diagram of a heat dissipation path of the power module shown in FIG. 3a;
FIG. 4a is a schematic diagram of a structure of a substrate preparation process of a power module according to an embodiment of this application;
FIG. 4b is a schematic diagram of a structure of a substrate preparation process of a power module according to an embodiment of this application;
FIG. 5a is a schematic diagram of a structure of a power module according to an embodiment of this application;
FIG. 5b is a schematic diagram of a heat dissipation path of the power module shown in FIG. 5a;
FIG. 6 is a schematic diagram of a structure of a power module according to an embodiment of this application;
FIG. 7a is a schematic diagram of a structure of a substrate preparation process of a power module according to an embodiment of this application;
FIG. 7b is a schematic diagram of a structure of a substrate preparation process of a power module according to an embodiment of this application;
FIG. 7c is a schematic diagram of a structure of a substrate preparation process of a power module according to an embodiment of this application;
FIG. 8 is a schematic diagram of a structure of a power module according to an embodiment of this application;
FIG. 9a is a schematic diagram of a structure of a substrate preparation process of a power module according to an embodiment of this application;
FIG. 9b is a schematic diagram of a structure of a substrate preparation process of a power module according to an embodiment of this application;
FIG. 9c is a schematic diagram of a structure of a substrate preparation process of a power module according to an embodiment of this application;
FIG. 9d is a schematic diagram of a structure of a substrate preparation process of a power module according to an embodiment of this application;
FIG. 10a is a schematic diagram of a structure of a power module according to an embodiment of this application;
FIG. 10b is a schematic diagram of a structure of a power module according to an embodiment of this application;
FIG. 11a is a schematic diagram of a structure of a power module according to an embodiment of this application;
FIG. 11b is a schematic diagram of a structure of a power module according to an embodiment of this application;
FIG. 12 is a schematic diagram of a power conversion circuit of a power module according to an embodiment of this application;
FIG. 13a is a schematic diagram of a charging device according to an embodiment of this application; and
FIG. 13b is a schematic diagram of a charging device according to an embodiment of this application.

### DESCRIPTION OF EMBODIMENTS

In the field of power electronics technologies, high density power can be achieved by assembling a power component by using a surface-mount technology. A power module is used as an example. As power consumption of a device such as a server continuously increases, the power module gradually develops towards high frequency and magnetic component planarization, to improve power density of the power module. Specifically, the power density of the power module may be increased by using a surface-mounted power component. A heat dissipation pad of the surface-mounted power component in the power module is a fluctuation point of a high-frequency voltage. If a heat sink is directly connected to the heat dissipation pad, this heat dissipation manner may cause serious safety problems. To avoid safety problems, sufficient space needs to be reserved for heat dissipation. However, this conflicts with design of high power density. In addition, electromagnetic interference (electromagnetic interference, EMI) may be generated if the heat sink carries electricity. Therefore, electrical isolation of the heat sink needs to be implemented during heat dissipation of the component.

Based on this, embodiments of this application provide a power module and a charging device. The power module has advantages of a small size and high heat dissipation efficiency, and can avoid an electromagnetic interference problem caused by a heat sink carrying electricity.

To describe the technical solutions in embodiments of this application more clearly, the following describes in detail the power module and the charging device that are provided in embodiments of this application with reference to the accompanying drawings.

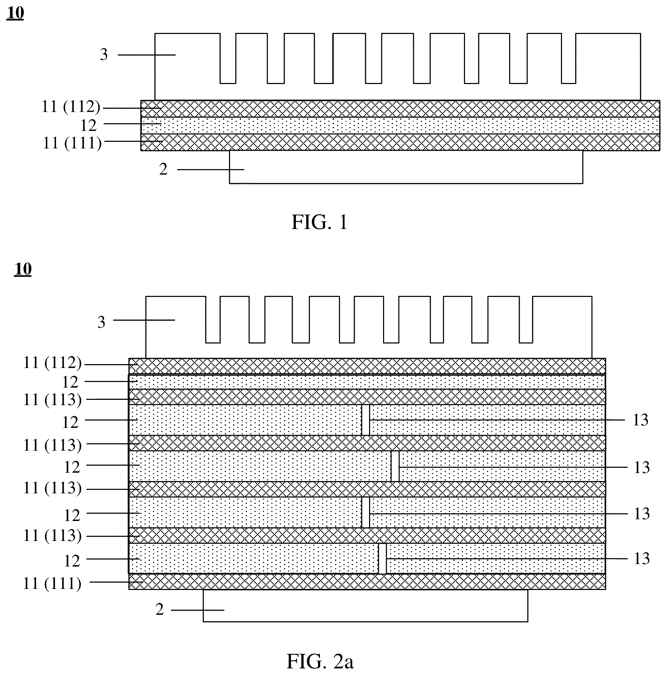

As shown in FIG. 1, a power module 10 provided in embodiments of this application may specifically include a substrate 1, a power component 2, and a heat sink 3. The power component 2 may be specifically a metal oxide field-effect transistor (metal oxide semiconductor field-effect transistor, MOSFET), an insulated gate bipolar transistor (insulated gate bipolar transistor, IGBT), a diode, a gallium nitride (gallium nitride, GaN), or a silicon carbide (silicon carbide, SiC); or a combination of at least two thereof. The metal oxide field-effect transistor is used as an example. The power component 2 generates heat during operation. To ensure normal operation of the component, heat dissipation needs to be performed on the power component 2.

As shown in FIG. 1, the substrate 1 is of a multi-layer line board structure, and specifically includes at least two conductive layers 11. The at least two conductive layers 11 are stacked along a thickness direction of the substrate 1. It may also be considered that all the conductive layers 11 are stacked along the thickness direction of the substrate 1. An insulating dielectric layer 12 is disposed between any two adjacent conductive layers 11. The conductive layer 11 may be a metal layer, for example, a copper layer. Alternatively, the conductive layer 11 may be of another material that has a conductive property, for example, an indium tin oxide (indium tin oxide, ITO) film layer. Alternatively, the conductive layer 11 may be of a combination structure of a metal layer and another material, provided that the conductive layer 11 can perform a conductive function.

For example, the at least two conductive layers 11 include a first conductive layer 111 and a second conductive layer 112. Along the thickness direction of the substrate 1, the first conductive layer 111 and the second conductive layer 112 are respectively located on two surfaces of the substrate 1. The power component 2 is mounted on a surface that is of the first conductive layer 111 and that is away from the second conductive layer 112 by using a surface-mount technology. Through such a mounting manner, not only a volume of the power module 10 can be reduced, but also power density of the power module 10 can be improved. This is conducive to miniaturization of the power module 10. Compared with that of a heat dissipation manner of a plug-in component, space occupation of the power module 10 provided in embodiments of this application can be reduced by about 50%. The heat sink 3 is mounted, by using a technology such as welding, on a surface that is of the second conductive layer 112 and that is away from the first conductive layer 111. The heat sink 3 may make full use of space on a side that is of the substrate 1 and on which the second conductive layer 112 is disposed, so that a volume of the heat sink 3 may be large enough. The volume of the heat sink 3 is increased, so that the heat sink 3 can achieve a larger heat exchange area, thereby improving heat exchange efficiency. Compared with that of a heat dissipation manner in which the heat sink is mounted next to the power component, a heat dissipation capability of the power module 10 provided in embodiments of this application can be about doubled. The heat sink 3 can achieve heat dissipation through heat exchange via water cooling, wind cooling, or the like.

According to the power module 10 provided in embodiments of this application, heat generated by the power component 2 may be transferred to the heat sink 3 through the substrate 1, and then the heat sink 3 transfers the heat to the outside through heat exchange. The substrate 1 is used as a reference. The power component 2 and the heat sink 3 are respectively located on two sides along the thickness direction of the substrate 1. Based on the line board structure of the substrate 1, the second conductive layer 112 may be isolated from another conductive layer 11 through the insulating dielectric layer 12 in the substrate 1. In this way, the heat sink 3 mounted on the second conductive layer 112 can be grounded, thereby avoiding electromagnetic interference caused by the heat sink 3 carrying electricity.

It should be understood that, in a process in which the heat generated by the power component 2 passes through the substrate 1, a heat conduction rate of the conductive layer 11 is generally higher than a heat conduction rate of the insulating dielectric layer 12. Most heat may be transferred along a thickness direction of the conductive layer 11, but a small part of heat may also be transferred in a plane in which the conductive layer 11 is located. The power module 10 provided in embodiments of this application is mainly for a case in which the heat of the power component 2 is transferred to the heat sink 3 along the thickness of the substrate 1.

Specifically, in the power module 10 shown in FIG. 1, the substrate 1 includes the two conductive layers 11. The two conductive layers 11 are respectively the first conductive layer 111 and the second conductive layer 112. The power component 2 is mounted on the first conductive layer 111, and the heat sink 3 is connected to the second conductive layer 112. The insulating dielectric layer 12 between the first conductive layer 111 and the second conductive layer 112 can implement electrical insulation of the heat sink 3, to avoid electromagnetic interference caused by the heat dissipation pad of the heat sink on the power component. The heat generated by the power component 2 may be transferred to the heat sink 3 for heat dissipation through the first conductive layer 111, the insulating dielectric layer 12, and the second conductive layer 112.

In some other embodiments, as shown in FIG. 2a, the substrate 1 includes at least three conductive layers 11, and the at least three conductive layers 11 include the first conductive layer 111, the second conductive layer 112, and at least one intermediate conductive layer 113. All intermediate conductive layers 113 are located between the first conductive layer 111 and the second conductive layer 112. For example, there are four intermediate conductive layers 113. Along a direction from the second conductive layer 112 to the first conductive layer 111, the 1st intermediate conductive layer 113 and the second conductive layer 112 are insulated from each other, to ensure that the heat sink 3 connected to the second conductive layer 112 is electrically insulated. It may be considered that, along the direction from the second conductive layer 112 to the first conductive layer 111, in all the intermediate conductive layers 113, the 1st intermediate conductive layer 113 is closest to the second conductive layer 112, and the last intermediate conductive layer 113 is closest to the first conductive layer 111. In the power module 10 shown in FIG. 2a, an intermediate conductive layer 113 that is closest to the first conductive layer 111 is located at the bottom of all the intermediate conductive layers 113, and an intermediate conductive layer 113 that is closest to the second conductive layer 112 is located at the top of all the intermediate conductive layers 113. That is, the intermediate conductive layer 113 that is closest to the second conductive layer 112 is electrically insulated from the second conductive layer 112.

Still as shown in FIG. 2a, an insulating dielectric layer 12 is also disposed between the second conductive layer 112 and the intermediate conductive layer 113 that is closest to the second conductive layer 112, an insulating dielectric layer 12 is disposed between the first conductive layer 111 and the intermediate conductive layer 113 that is closest to the first conductive layer 111, and an insulating dielectric layer 12 is disposed between any two adjacent intermediate conductive layers 113. To ensure electrical insulation of the heat sink 3, the insulating dielectric layer 12 between the second conductive layer 112 and the intermediate conductive layer 113 that is closest to the second conductive layer 112 has no metal via hole, so that the second conductive layer 112 and the intermediate layer 113 that is closest to the second conductive layer 112 are insulated from each other, and the heat sink 3 is insulated from another conductive layer 11 except the second conductive layer 112.

The insulating dielectric layer 12 between the second conductive layer 112 and the intermediate conductive layer 113 that is closest to the second conductive layer 112 can perform an insulation function. On the premise of ensuring the insulation function, a thickness of the insulating dielectric layer 12 can be reduced as much as possible, to facilitate heat dissipation. In addition, the insulating dielectric layer 12 may alternatively be prepared by using an insulation material with a good thermal conductivity, to improve heat dissipation efficiency.

On the premise that the heat conduction rate of the conductive layer 11 is higher than the heat conduction rate of the insulating dielectric layer 12, to improve the heat transfer rate, other conductive layers 11 except the second conductive layer 112 may be connected through a metal via hole 13, and the metal via hole 13 can quickly guide heat from one conductive layer 11 to the other conductive layer 11. Specifically, the insulating dielectric layer 12 between the intermediate conductive layer 113 that is closest to the first conductive layer 111 and the first conductive layer 111 is provided with a metal via hole 13, and the metal via hole 13 may connect, to the first conductive layer 111, the intermediate conductive layer 113 that is closest to the first conductive layer 111. A metal via hole 13 is also disposed at an insulating dielectric layer 12 between any two adjacent intermediate conductive layers 113, and the metal via hole 13 can connect the two adjacent intermediate conductive layers 113. It should be understood that existence of the metal via hole 13 enables most heat to be transferred more quickly through the metal via hole 13, but it is not excluded that a small part of heat is still transferred through the insulating dielectric layer 12. The metal via hole 13 may be implemented by filling a metal material in the hole, or may be implemented by electroplating a conductive layer on an inner wall of the hole.

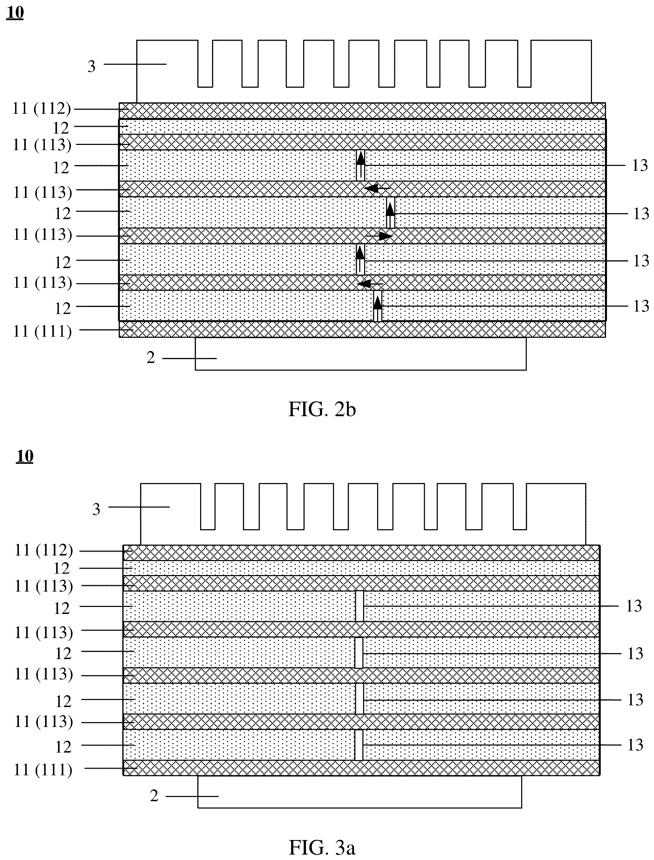

Based on the power module 10 shown in FIG. 2a, as shown in FIG. 2b, a main heat dissipation path formed when heat of the power component 2 is transferred on the substrate 1 is shown by arrows. The metal via hole 13 can accelerate a heat transfer speed and heat transfer efficiency between the conductive layers 11 on two sides of the metal via hole 13, and any two adjacent metal via holes 13 transfer heat through the conductive layers 11. It may be considered that the metal via hole 13 is on the heat dissipation path for heat transfer.

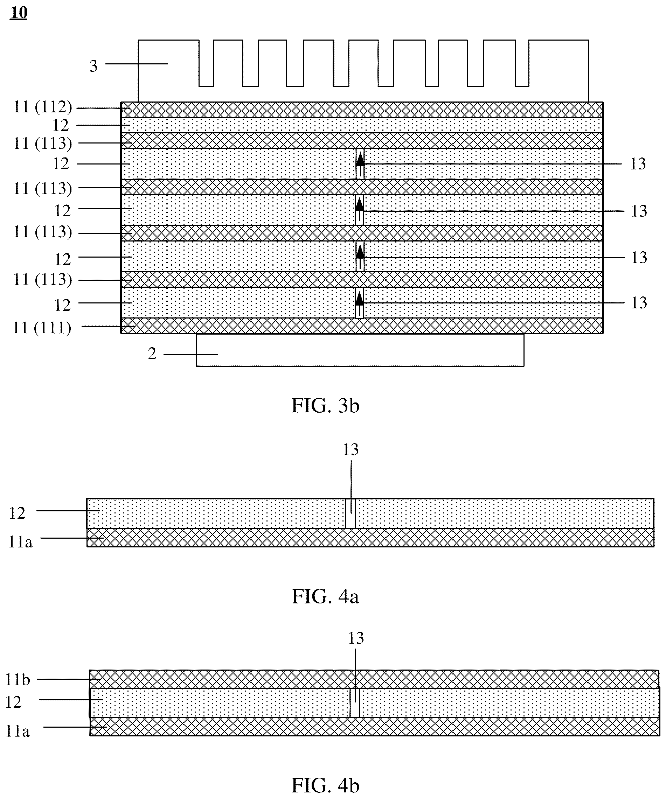

To improve heat dissipation efficiency, as shown in FIG. 3a, metal via holes 13 on different insulating dielectric layers 12 may approximately correspond to each other along the thickness direction of the substrate 1. If the metal via holes 13 have center lines extending along the thickness direction of the substrate 1, it may be considered that the center lines of the metal via holes 13 are approximately collinear. For example, when the metal via holes 13 are cylindrical, axes of metal via holes 13 in a same metal via hole group G may keep overlapping, and a heat dissipation path formed by the metal via holes 13 in the metal via hole group G overlaps the axes of the metal via holes 13. As shown in FIG. 3b, a main heat dissipation path formed when the heat of the power component 2 is transferred on the substrate 1 is shown by arrows. Correspondence of the metal via holes 13 along the thickness direction of the substrate 1 can ensure a shortest heat dissipation path, to improve a heat dissipation rate and heat dissipation efficiency.

Certainly, to reduce a technique difficulty, the metal via holes 13 approximately correspond to each other along the thickness direction of the substrate 1. For example, orthographic projections of any two adjacent metal via holes 13 on the first conductive layer 111 at least partially overlap along the thickness direction of the substrate 1, in other words, the metal via holes 13 may form a heat dissipation path that approximately extends along the thickness direction of the substrate 1.

In the power module 10 shown in FIG. 2a or FIG. 3a, each metal via hole 13 may be manufactured when each insulating dielectric layer 12 is formed. As shown in FIG. 4a, after a conductive layer 11a and an insulating dielectric layer 12 are formed through stacking, a metal via hole 13 is formed on the insulating dielectric layer 12 by using a technology such as hole filling and plating, and the metal via hole 13 runs through the insulating dielectric layer 12 and is connected to the conductive layer 11a. Then, as shown in FIG. 4b, another conductive layer 11b is formed on a surface that is of the insulating dielectric layer 12 and that is away from the conductive layer 11a. The conductive layer 11b is in contact with the metal via hole 13, and the metal via hole 13 may connect the conductive layer 11a and the conductive layer 11b. By analogy, the substrate 1 in FIG. 2a or FIG. 3b may be obtained by continuing to stack the insulating dielectric layer 12 and the conductive layer 11.

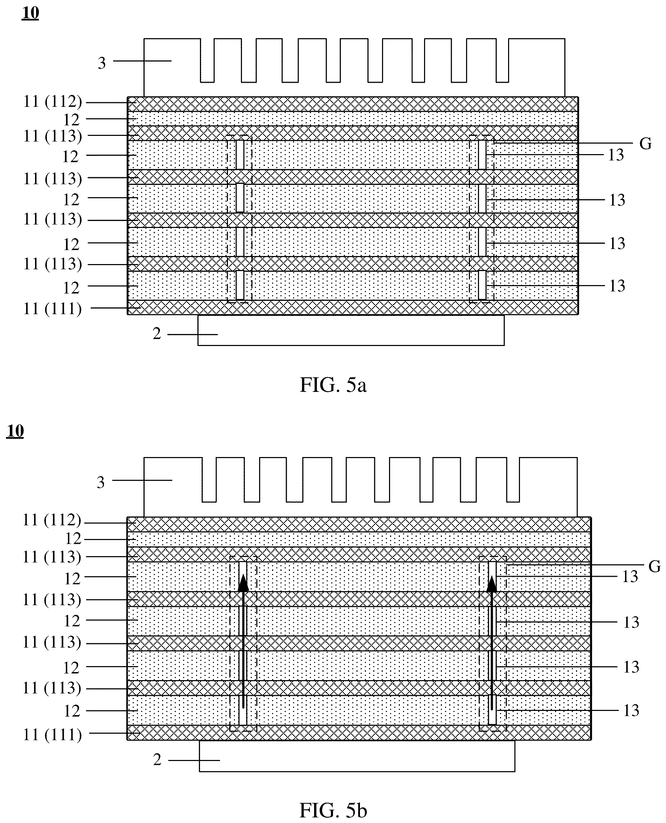

In some embodiments, as shown in FIG. 5a, between the first conductive layer 111 and the intermediate conductive layer 113 that is closest to the second conductive layer 112, two or more metal via holes 13 are disposed on each insulating dielectric layer 12. Two metal via holes 13 are used as an example herein. Metal via holes 13 on different insulating dielectric layers 12 may be distributed according to a rule, and metal via holes 13 on a plurality of different insulating dielectric layers 12 that are sequentially corresponding along the thickness direction of the substrate 1 are grouped into a metal via hole group G. FIG. 5a shows an example of two metal via hole groups G, and metal via holes 13 in each metal via hole group G are approximately on a same heat dissipation path along the thickness direction of the substrate 1. If the metal via holes 13 have center lines extending along the thickness direction of the substrate 1, it may be considered that the center lines of the metal via holes 13 in each metal via hole group G are approximately collinear, to ensure a shortest heat dissipation path and improve a heat dissipation rate and heat dissipation efficiency. Specifically, along the thickness direction of the substrate 1, orthographic projections of any two adjacent metal via holes 13 in a same metal via hole group G on the first conductive layer 111 may overlap. For example, when the metal via holes 13 are cylindrical, axes of metal via holes 13 in a same metal via hole group G may keep overlapping, and a heat dissipation path formed by the metal via holes 13 in the metal via hole group G overlaps the axes of the metal via holes 13.

As shown in FIG. 5b, a main heat dissipation path formed when the heat of the power component 2 is transferred on the substrate 1 is shown by arrows. With reference to a direction in which the power component 2 points to the heat sink 3, heat is transferred from the power component 2 to the heat sink 3 after passing through the substrate 1. In a heat transfer process, most heat is transferred along the metal via holes 13 in each metal via hole group G on the insulating dielectric layer 12.

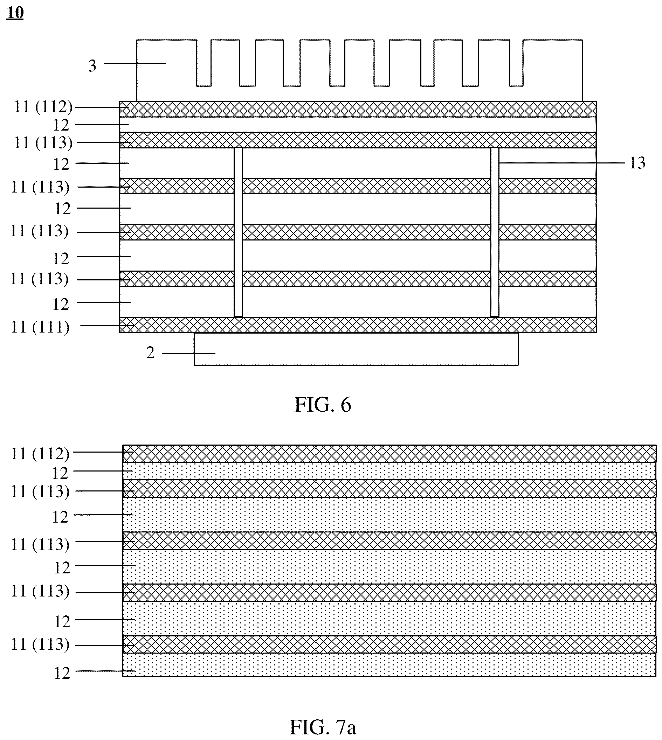

Possibly, as shown in FIG. 6, the metal via hole 13 may extend from the first conductive layer 111 to the intermediate conductive layer 113 that is closest to the second conductive layer 112. That is, the metal via hole 13 may be sequentially connected to the first conductive layer 111 and all the intermediate conductive layers 113. The metal via hole 13 may be disposed in a tilt manner, or the metal via hole 13 may extend along the thickness direction of the substrate 1. When the metal via hole 13 extends along the thickness direction of the substrate 1, the metal via hole 13 is equivalent to being perpendicular to the first conductive layer 111, and a heat dissipation path distance of the power component 2 for heat dissipation through the metal via hole 13 is the shortest, and a heat dissipation speed is higher.

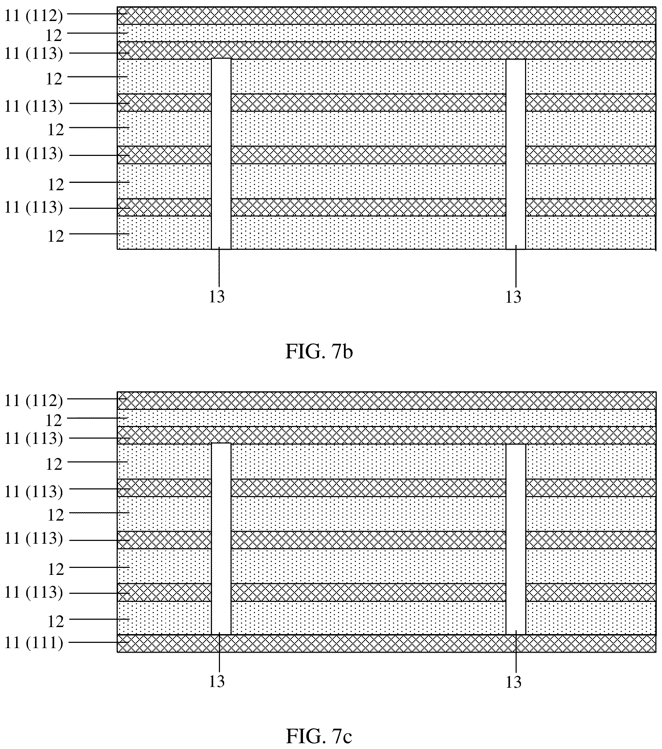

In a process of preparing the substrate 1 shown in FIG. 6, each intermediate conductive layer 113 and the insulating dielectric layer 12 in the substrate 1 may be manufactured to obtain a structure shown in FIG. 7a. Then, a metal via hole 13 is formed by using the technology such as hole filling and plating, to obtain a structure shown in FIG. 7b. The metal via hole 13 can be connected to all the intermediate conductive layers 113. Then, as shown in FIG. 7c, a first conductive layer 111 is disposed at the bottom of the structure shown in FIG. 7b, and the first conductive layer 111 is in contact with and connected to the metal via hole 13, to obtain a structure shown in FIG. 7c. In this way, any two adjacent conductive layers 11 of the first conductive layer 111 and all the intermediate conductive layers 113 are connected through the metal via hole 13. Two metal via holes 13 are used as an example herein, and each metal via hole 13 can be connected to the first conductive layer 111 and all the intermediate conductive layers 113 at the same time.

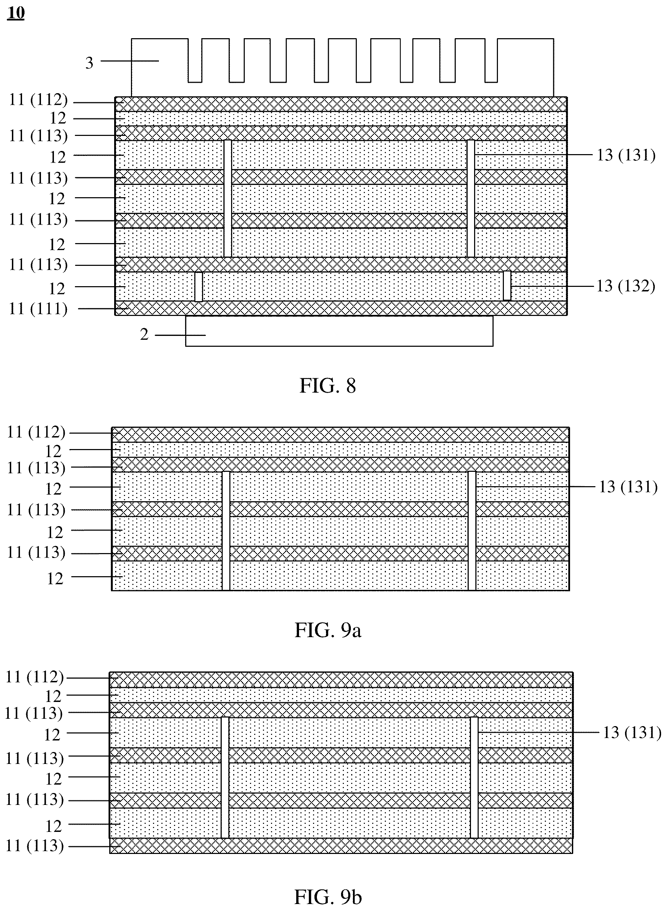

In some embodiments, considering a preparation technique of the substrate 1, the first conductive layer 111 may be prepared after all the intermediate conductive layers 113 are prepared. Therefore, as shown in FIG. 8, all the intermediate conductive layers 113 may be connected through the metal via hole 13, and the metal via hole 13 is defined as a first metal via hole 131. The metal via hole 13 between the first conductive layer 111 and the intermediate conductive layer 113 that is closest to the first conductive layer 111 is defined as a second metal via hole 132. The first metal via hole 131 may not correspond to the second metal via hole 132 along the thickness direction of the substrate 1.

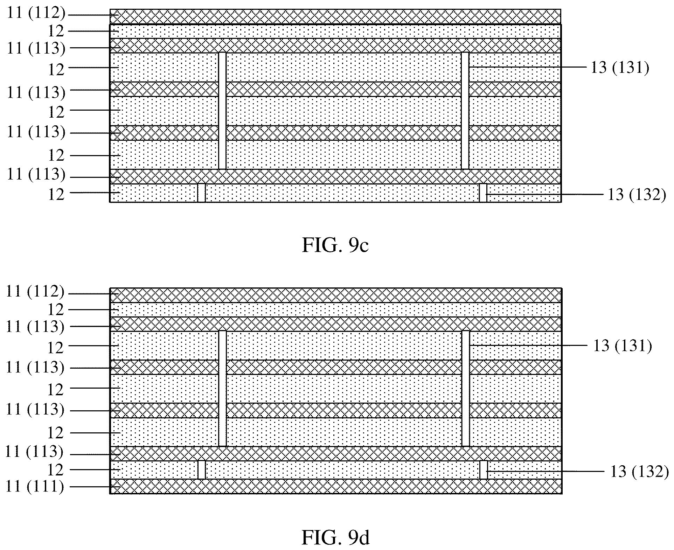

In the process of preparing the substrate 1 shown in FIG. 8, the second conductive layer 112, another intermediate conductive layer 113 except the intermediate conductive layer 113 that is closest to the first conductive layer 111, and the insulating dielectric layer 12 may be stacked in sequence, and the first metal via hole 131 is formed by using the technology such as hole filling and plating. The first metal via hole 131 extends to the intermediate conductive layer 113 that is closest to the second conductive layer 112, to obtain a structure shown in FIG. 9a. Then, an intermediate conductive layer 113 is disposed at the bottom of the structure shown in FIG. 9a, and the intermediate conductive layer 113 is an intermediate conductive layer 113 that is farthest from the second conductive layer 112, to obtain a structure shown in FIG. 9b. In this case, all intermediate conductive layers 113 are connected through the first metal via hole 131. Then, an insulating dielectric layer 12 is stacked at the bottom of the structure shown in FIG. 9b, and the second metal via hole 132 is formed by using the technology such as hole filling and plating. The second metal via hole 132 extends to an intermediate conductive layer 113 that is farthest from the second conductive layer 112, to obtain a structure shown in FIG. 9c. A first conductive layer 111 is disposed at the bottom of the structure shown in FIG. 9c, to obtain a structure shown in FIG. 9d. In this way, any two adjacent conductive layers 11 of the first conductive layer 111 and all the intermediate conductive layers 113 are connected through the metal via hole 13. With reference to FIG. 9a to FIG. 9d, when the first conductive layer 111 and the second metal via hole 132 that is closest to the first conductive layer 111 are prepared, alignment may not need to be performed with the first metal via hole 131, thereby reducing a technique difficulty, reducing production costs, and improving production efficiency.

It should be understood that there may be another possibility of a quantity and a distribution form of metal via holes 13, provided that the metal via hole 13 is disposed between any two adjacent conductive layers 11 on the first conductive layer 111 and all the intermediate conductive layers 113. The metal via hole 13 may be adjusted according to a requirement during specific preparation. This is not limited in this application.

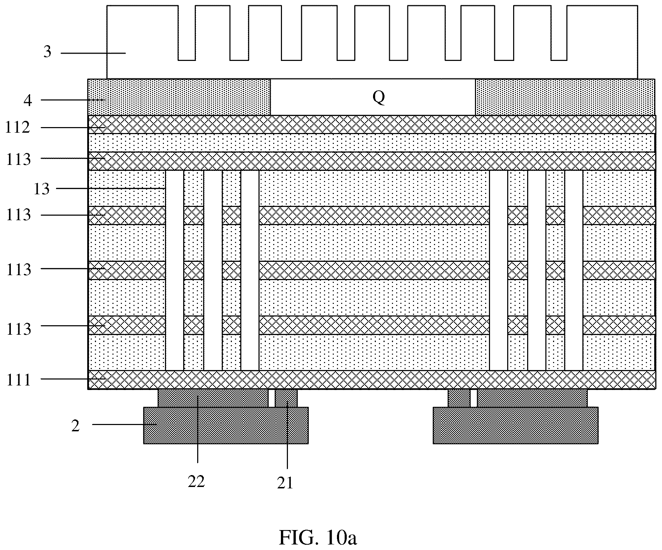

As shown in FIG. 10a, the heat sink 3 is welded to the second conductive layer 112 through a plurality of heat dissipation pads 4. The power component 2 has a control electrode 21 and a connection electrode 22, and the connection electrode 22 and the control electrode 21 of the power component 2 are respectively connected to the first conductive layer 111. The connection electrode 22 may be specifically a source electrode or a drain electrode of the power component 2, and heat generated by the power component 2 may be transferred to the first conductive layer 111 through the connection electrode 22. The control electrode 21 may be specifically a gate electrode of the power component 2, and may be used for signal interaction between the power component 2 and a controller.

Herein, the plurality of heat dissipation pads 4 include two or more heat dissipation pads 4. Each heat dissipation pad 4 is disposed independently, so that a gap Q exists between any two heat dissipation pads 4. When the power module 10 is used, the power component 2 generates heat, and the heat is transferred to the heat sink 3 through the substrate 1, and the heat sink 3 may also be deformed to some extent in a heat exchange process. The heat sink 3 is connected to the substrate 1 by using a structure in which the plurality of heat dissipation pads 4 are connected to the substrate 1. The gap Q exists between the heat dissipation pads 4, so as to play a specific deformation buffering function, absorb deformation energy, and prevent deformation of the heat sink 3 from affecting reliability and stability of a connection between the power component 2 and the substrate 1 by using the substrate 1.

Still as shown in the power module 10 shown in FIG. 10a, heat dissipated by the power component 2 is transferred to the first conductive layer 111 through the connection electrode 22, and then transferred to the heat sink 3 through the substrate 1. To shorten a heat dissipation path, the heat dissipation pad 4, the metal via hole 13, and the connection electrode 22 may correspond to each other along the thickness direction of the substrate 1. Specifically, along the thickness direction of the substrate 1, an orthographic projection of the metal via hole 13 on the second conductive layer 112 at least partially overlap an orthographic projection of the connection electrode 22 on the second conductive layer 112, and an orthographic projection of the metal via hole 13 on the second conductive layer 112 at least partially overlaps an orthographic projection of the heat dissipation pad 4 on the second conductive layer 112. Therefore, in a process of transferring the heat dissipated by the power component 2 to the heat sink 3, the heat dissipation path can be kept parallel to a thickness direction of the substrate 1 as much as possible, to achieve a quick heat dissipation effect.

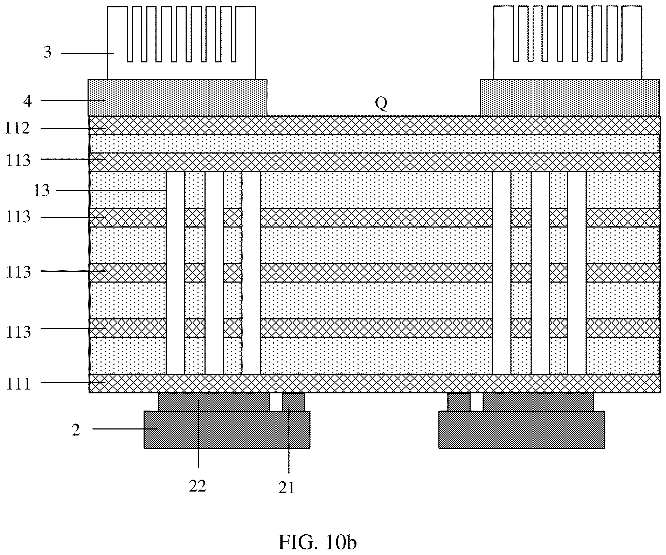

In FIG. 10a, two power components 2 are disposed, one heat sink 3 is disposed, and the heat sink 3 is connected to the second conductive layer 112 through two heat dissipation pads 4. Three groups of metal via holes 13 are disposed for each power component 2, and one heat dissipation pad 4 is correspondingly disposed for each power component 2. It should be understood that a quantity of heat sinks 3 does not need to have a specific correspondence with the power component 2. For example, as shown in FIG. 10b, two heat sinks 3 are disposed, and the two heat sinks 3 are in a one-to-one correspondence with the two power components 2 along the thickness direction of the substrate 1. A plurality of groups of metal via holes 13 may be disposed between the heat sink 3 and the power component 2 that correspond to each other, to optimize a heat dissipation effect.

As shown in FIG. 10a and FIG. 10b together, an orthographic projection of a welding position of the control electrode 21 on the first conductive layer 111 on the second conductive layer 112 does not overlap an orthographic projection of any heat dissipation pad 4 on the second conductive layer 112. In other words, the gap Q between the welding position of the control electrode 21 on the first conductive layer 111 and the heat dissipation pad 4 corresponds to the thickness direction of the substrate 1. In this structure, a connection position between the control electrode 21 and the first conductive layer 111 is away from a position of the heat dissipation pad 4 of the heat sink 3. This improves reliability of the component.

In conclusion, according to the power module 10 provided in embodiments of this application, the power component 2 is mounted on the substrate 1 by using a surface-mount technology, to facilitate component miniaturization and provide power density. The heat sink 3 is disposed on a side that is of the substrate 1 and that is away from the power component 2, so that the heat sink 3 can have a relatively large volume to improve heat dissipation efficiency. Electrical insulation may be performed between the heat sink 3 and the conductive layer 11 of the substrate 1 through the insulating dielectric layer 12 of the substrate 1, to prevent electromagnetic interference caused by the heat sink 3 carrying electricity. In a process in which heat generated by the power component 2 is transferred to the heat sink 3 through the substrate 1, the metal via hole 13 can improve heat dissipation efficiency.

Therefore, the power module 10 provided in embodiments of this application can have both a relatively high heat dissipation capability and a relatively good electrical isolation capability, and has a good development prospect. It should be understood that the power component 2 and the heat sink 3 in the power module 10 provided in embodiments of this application may be further applied to fields such as laser and photovoltaic after being adjusted and deformed by using the substrate 1 for heat conduction and heat dissipation.

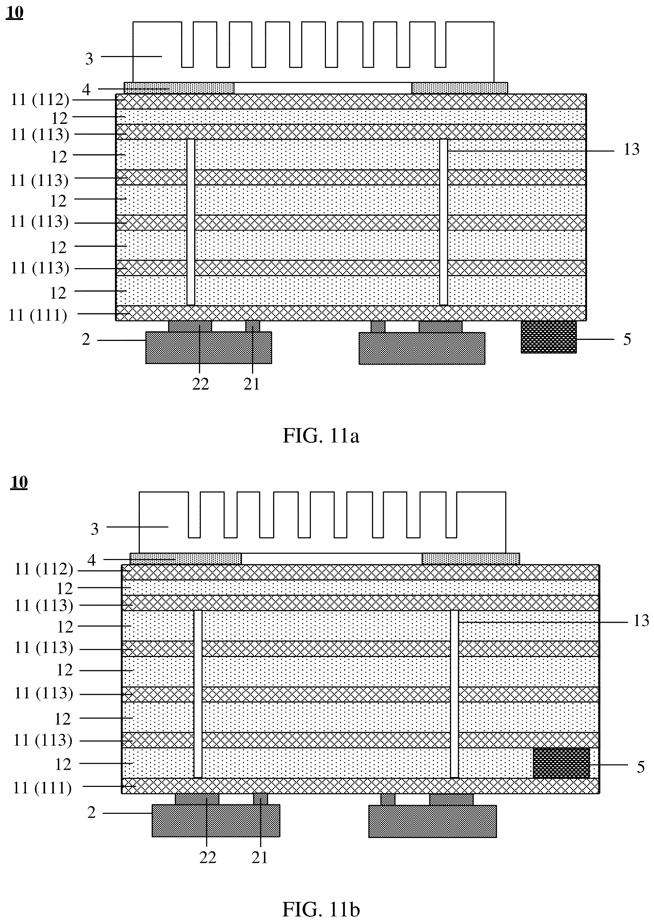

As shown in FIG. 11a, the power module 10 provided in embodiments of this application may further include a capacitor component 5. The capacitor component 5 may be mounted on a side that is of the first conductive layer 111 and that is away from the second conductive layer 112. Alternatively, as shown in FIG. 11b, the capacitor component 5 may be embedded in the substrate 1. This is not limited in embodiments of this application. Certainly, the power module 10 may further have other components such as an inductor and a resistor, which are not shown in detail herein.

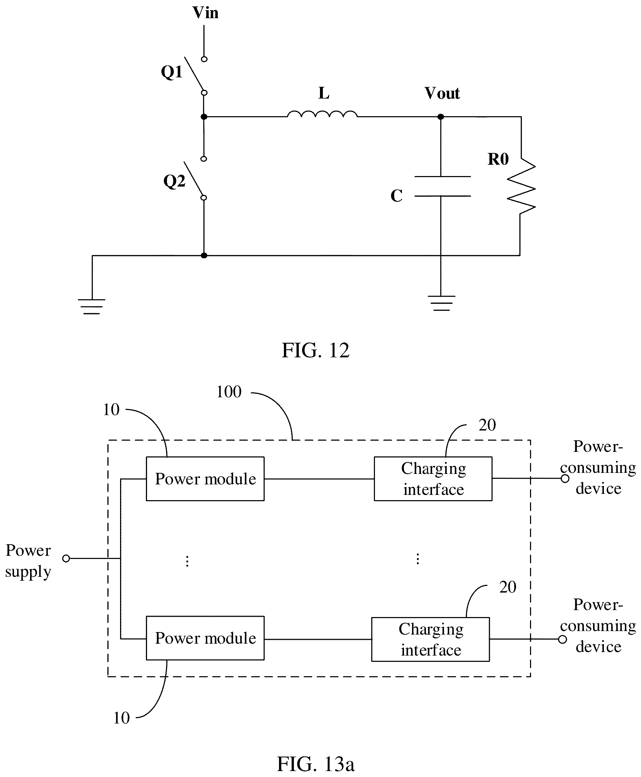

As shown in FIG. 11a and FIG. 11b, the capacitor component 5 is connected to the power component 2 through the first conductive layer 111 to form a power conversion circuit shown in FIG. 12. The power conversion circuit includes a first power tube switch Q1, a second power tube switch Q2, a capacitor C, an inductor L, and a load R. The first power tube switch Q1 and the second power tube switch Q2 may be the power components 2 in embodiments of this application, or it may be considered that the power component 2 may implement functions of the first power tube switch Q1 and the second power tube switch Q2. The capacitor C may be the capacitor component 5 in embodiments of this application. The power conversion circuit may convert a high voltage input by a Vin into a low voltage, and output the low voltage from a Vout to a load R0 to supply power to the load.

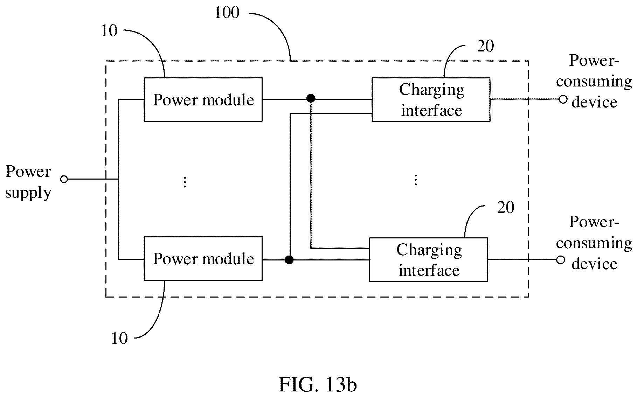

The power module 10 provided in embodiments of this application may be applied to a charging device 100 shown in FIG. 13a or FIG. 13b. The charging device 100 may be considered as a charging device such as a charging pile or a charger. The charging device 100 includes at least one power module 10 and at least one charging interface 20. The power conversion circuit in the power module 10 may convert a current supplied by a power supply. The charging interface 20 is configured to supply a current output by the power module 10 to a power-consuming device, for example, an electric vehicle or a terminal. The power supply may be a mains supply, a generator, or an uninterruptible power supply (uninterruptible power supply, UPS).

There may be a plurality of implementations for connection between the charging interface 20 and the power module 10. FIG. 13a and FIG. 13b are separately used as examples for description herein.

In FIG. 13a, each power module 10 is connected to one charging interface 20 in a one-to-one correspondence. Between the power module 10 and the charging interface 20 that correspond to each other, an input end of the charging interface 20 is connected to an output end of the power module 10, and an output end of the charging interface 20 is configured to be connected to the power-consuming device, to transmit, to the power-consuming device, a current output by the power module 10.

In FIG. 13b, each power module 10 may be simultaneously connected to at least one charging interface 20. In each power module 10 and all charging interfaces 20 corresponding to the power module 30, the power module 10 has a plurality of output ends, each output end is connected to an input end of one charging interface 20, and an output end of each charging interface 20 is configured to be connected to a charging device, so as to transmit a current output by the power module 10 to the power-consuming device.

Apparently, a person skilled in the art may make various modifications and variations to embodiments of this application without departing from the scope of embodiments of this application. This application is also intended to cover these modifications and variations of embodiments of this application provided that they fall within the scope of protection defined by the following claims and their equivalent technologies.

## Claims

1. A power module (10), comprising:
a substrate (1), comprising at least two conductive layers (11), wherein the at least two conductive layers (11) are stacked, an insulating dielectric layer (12) is disposed between any two adjacent conductive layers (11), the at least two conductive layers (11) comprise a first conductive layer (111) and a second conductive layer (112), and the first conductive layer (111) and the second conductive layer (112) are located on two surfaces in a thickness direction of the substrate (1);
a power component (2), wherein the power component (2) is mounted on a surface that is of the first conductive layer (111) and that is away from the second conductive layer (112); and
a heat sink (3), wherein the heat sink (3) is disposed on a surface that is of the second conductive layer (112) and that is away from the first conductive layer (111).

2. The power module (10) according to claim 1, wherein in the at least one intermediate conductive layer (113) and the first conductive layer (111), a metal via hole (13) is disposed on an insulating dielectric layer (12) between any two adjacent conductive layers (11).

3. The power module (10) according to claim 1 or 2, wherein an insulating dielectric layer (12) between the second conductive layer (112) and an intermediate conductive layer (113) that is closest to the second conductive layer (112) has no metal via hole.

4. The power module (10) according to any one of claims 1 to 3, wherein the heat sink (3) is connected to the substrate (1) through a plurality of heat dissipation pads (4); and
the power component (2) comprises a control electrode (21), and an orthographic projection of a welding position of the control electrode (21) and the first conductive layer (111) on the second conductive layer (112) does not overlap an orthographic projection of any heat dissipation pad (4) on the second conductive layer (112).

5. The power module (10) according to any one of claims 1 to 4, wherein the power module (10) further comprises a capacitor component (5), and the capacitor component (5) is connected to the power component (2) through the first conductive layer (111) to form a power conversion circuit.

6. A charging device (100), comprising at least one charging interface (20) and at least one power module (10) according to any one of claims 1 to 5, wherein
an input end of the charging interface (20) is configured to be connected to an output end of the power module (10); and
an output end of the charging interface (20) is configured to be connected to a power-consuming device, to transmit, to the power-consuming device, a current output by the power module (10).
